# EUROPÄISCHE PATENTSCHRIFT

(11) **EP 3 299 220 B1**
(45) Veröffentlichungstag und Bekanntmachung des Hinweises auf die Patenterteilung: **16.12.2020**
(21) Anmeldenummer: 17190042.6
(22) Anmeldetag: 08.09.2017
(51) Int. Cl.: F21S 45/70

(54) **BELEUCHTUNGSEINRICHTUNG FÜR EIN KRAFTFAHRZEUG**
LIGHTING DEVICE FOR A MOTOR VEHICLE
DISPOSITIF D'ÉCLAIRAGE DE VÉHICULE AUTOMOBILE

(30) Priorität: 21.09.2016 DE 102016117840
(43) Veröffentlichungstag der Anmeldung: 28.03.2018
(73) Patentinhaber: Automotive Lighting Reutlingen GmbH, 72762 Reutlingen (DE)
(72) Erfinder: Hiegler, Michael, 72760 Reutlingen (DE); Johann, Christian, 72770 Reutlingen (DE)
(74) Vertreter: DREISS Patentanwälte PartG mbB

(56) Entgegenhaltungen:
- WO-A1-2009/095829
- WO-A2-2010/004477
- DE-A1-102008 016 095
- US-A1- 2011 084 609

## Beschreibung

Die Erfindung betrifft eine Beleuchtungseinrichtung für ein Kraftfahrzeug nach dem Oberbegriff des Anspruchs 1 sowie ein Verfahren zum Betreiben der Beleuchtungseinrichtung nach dem Oberbegriff eines nebengeordneten Anspruchs.

Kraftfahrzeugscheinwerfer, die eine Laserlichtquelle zur Lichterzeugung umfassen, können im Falle einer Beschädigung zu einem Austritt von Laserlicht führen, welches direkt von der Laserlichtquelle stammt. Dies kann insbesondere zu Augenschäden und durch Blendung anderer Verkehrsteilnehmer zu Unfällen führen.

Ein bekanntes Laserlichtmodul umfasst eine Laserdiode und ein Photolumineszenzelement, wobei ein mittels der Laserdiode erzeugtes Primärlichtbündel auf das Photolumineszenzelement trifft, und wobei das Photolumineszenzelement das auftreffende Primärlichtbündel in ein von dem Laserlichtmodul abgestrahltes Mischlichtbündel und in ein in das Laserlichtmodul rückgestrahltes Mischlichtbündel umfassend Lumineszenzlicht wandelt.

Des Weiteren ist bekannt, dass durch hohe thermische Belastungen ein Photolumineszenzelement, welches auch als Konverter bezeichenbar ist, anfällig für Beschädigungen ist. So kann dieses Photolumineszenzelement beispielsweise Risse aufweisen oder es kann sich von einem zugehörigen Träger ablösen. Darüber hinaus kann über die Lebensdauer der Beleuchtungseinrichtung das Photolumineszenzelement einer Degradation unterliegen, welche sich negativ auf das Konvertierungsverhalten auswirkt.

Auch sind Einrichtungen zur Detektion fehlerbehafteter Photolumineszenzelemente bekannt. So schlägt beispielsweise die DE 10 2012 220 481 A1 vor, eine Detektionseinrichtung derart auszubilden, dass eine Strahlungsintensität von in einem Primärraumwinkelbereich um eine Primärstrahlachse verlaufenden Lichtbündeln besser messbar ist. Es wird wenigstens eine Referenzdetektionseinrichtung vorgeschlagen, welche derart ausgebildet und angeordnet ist, dass eine Referenzstrahlungsintensität der Sekundärlichtverteilung außerhalb des Primärraumwinkelbereichs um die Primärstrahlachse messbar ist. Mit diesen Signalen soll eine fehlerhafte Veränderung der Photolumineszenzeigenschaften des Photolumineszenzelements erfassbar sein.

Die WO2010004477 offenbart eine laserbasierte Lichtquelle, die eine Laservorrichtung umfasst, die zum Erzeugen von Laserlicht einer vorbestimmten Laserwellenlänge und zum Emittieren dieses Laserlichts als Laserstrahl geeignet ist; eine Lichtkonversionsvorrichtung zum Umwandeln mindestens eines Teils des Laserlichts in umgewandeltes Licht; einen Laserausgabesensor zum Bestimmen eines Laserausgabesignals proportional zur Ausgabe des von der Laservorrichtung emittierten Laserlichts; einen Umwandlungslichtsensor zum Bestimmen eines Umwandlungslichtsignals proportional zur Ausgabe von umgewandeltem Licht, das von der Lichtwandlervorrichtung emittiert wird; und eine Steuerung, die zum Empfangen des Laserausgangssignals und des Umwandlungslichtsignals, zum Bestimmen eines Safe-to-Operation-Parameters basierend auf dem Laserausgangssignal und dem Umwandlungslichtsignal und zum Steuern des Betriebs der laserbasierten Lichtquelle basierend auf einem Vergleich des Safe-to-Operation-Parameters mit einem mindestens einen vorbestimmten Schwellenwert angepasst ist.

Die WO2009095829 offenbart ein Gehäuse mit mindestens zwei Stiften. Das Gehäuse umfasst eine Halbleiterstruktur mit einer ersten Funktion und eine elektrische Schaltung mit mindestens einem Schaltungselement mit einer zweiten Funktion. Die Struktur und die Schaltung sind mit den Stiften elektrisch verbunden. Darüber hinaus ist das Gehäuse betreibbar, um die erste und zweite Funktion durch Zeitmultiplexen eines ersten und zweiten Betriebssignals durch die Pins auszuführen. Schließlich ist die erste Funktion eine Beleuchtungsfunktion und die zweite Funktion eine Sensorfunktion.

Die bekannten Einrichtungen zur Detektion eines fehlerbehafteten Photolumineszenzelements weisen den Nachteil auf, dass diese mit einem erhöhten Aufwand einhergehen, was beispielsweise die Anordnung von Detektoreinrichtungen außerhalb des jeweiligen Laserlichtmoduls betrifft.

Mithin es Aufgabe der Erfindung, die bestehenden Beleuchtungseinrichtungen dahingehend weiterzubilden, dass diese vereinfacht werden und gleichzeitig die Betriebssicherheit des Laserlichtmoduls gewährleistet ist.

Hierzu wird vorgeschlagen, dass die Lichtintensität des rückgestrahlten, getakteten Lumineszenzlichts ermittelbar ist, und dass die Laserdiode in Abhängigkeit von der ermittelten Lichtintensität des rückgestrahlten, getakteten Lumineszenzlichts abschaltbar ist.

Durch die Messung des rückgestrahlten Lumineszenzlichts, welches sich in dem Innenraum des Laserlichtmoduls ausbreitet, können externe Messeinrichtungen, welche ein aus dem Laserlichtmodul austretendes Laserlicht messen, entfallen. Ein Nachleuchten des Lumineszenzlichts, welches durch das Photolumineszenzelement bei Bestrahlung mit dem getakteten Primärlichtbündel bewirkt wird, kann mittels eines Photostroms ermittelt werden. Insbesondere ein stark abgeschwächtes Intensitätssignal des nachleuchtenden Lumineszenzlichts, welches durch ein beschädigtes Photolumineszenzelement bewirkt wird, kann sicher erkannt werden. Ebenfalls kann eine Kompaktierung des Laserlichtmoduls bei gleichzeitiger Aufrechterhaltung der Betriebssicherheit erreicht werden.

Des weiteren ist eine Messvorrichtung zur Ermittlung der Lichtintensität des rückgestrahlten Lumineszenzlichts vorgesehen, die die Laserdiode und ein in einer Versorgungsleitung der Laserdiode angeordnetes Strommessglied umfasst, wobei ein von dem Strommessglied ermittelter Stromwert die Lichtintensität des rückgestrahlten Lumineszenzlichts repräsentiert. Vorteilhaft kann so die Laserdiode als Photodiode verwendet werden, um das in den Innenraum des Laserlichtmoduls zurück reflektierte Lumineszenzlichts zu erfassen.

Eine vorteilhaftes Beispiel der Beschreibung zeichnet sich dadurch aus, dass eine Messvorrichtung zur Ermittlung der Lichtintensität eine Photodiode umfasst, wobei ein von der Photodiode ermittelter Stromwert die Lichtintensität des rückgestrahlten Lumineszenzlichts repräsentiert.

Vorteilhaft kann auf diese Art und Weise der Betrieb der Laserdiode von der Messung der Intensität des rückgestrahlten Lumineszenzlichts mittels der Photodiode entkoppelt werden. Gleichzeitig kann die Erfassung des Lumineszenzlichts im Innenraum des Laserlichtmoduls erfolgen.

Eine vorteilhafte Ausführungsform zeichnet sich dadurch aus, dass das Laserlichtmodul ein im Wesentlichen lichtdichtes Gehäuse umfasst, wobei in eine Öffnung des Gehäuses das Photolumineszenzelement eingebracht ist, und wobei die Lichtintensität des rückgestrahlten Lumineszenzlichts in einem Innenraum des lichtdichten Gehäuses erfasst wird. Durch das lichtdichte Gehäuse wird verhindert, dass nicht gestreutes und damit potentiell gefährliches Laserlicht aus dem Laserlichtmodul austritt. Damit wird die Laserlichtquelle wirksam von einem Außenraum des Laserlichtmoduls abgeschottet.

Eine vorteilhafte Ausführungsform zeichnet sich dadurch aus, dass ein erster Zeitpunkt einer fallenden Flanke des getakteten Primärlichtbündels ermittelbar ist, wobei ein zweiter Zeitpunkt ermittelbar ist, zu dem die Lichtintensität des rückgestrahlten, getakteten Lumineszenzlichts unter einen vorgegebenen Lichtintensitätswert fällt, und wobei die Laserdiode in Abhängigkeit von dem ersten und dem zweiten Zeitpunkt abschaltbar ist. Damit wird ein einfaches Verfahren geschaffen, um ein beschädigtes Laserlichtmodul sicher abzuschalten.

Weitere vorteilhafte Ausführungsformen, Merkmale und Vorteile der Erfindung finden sich in der nachfolgenden Beschreibung der Zeichnung. Für funktionsäquivalente Merkmale werden in allen Figuren auch bei unterschiedlichen Ausführungsformen die gleichen Bezugszeichen verwendet. In der Zeichnung zeigen:
- Figuren 1 bis 3: jeweils ein schematisches Blockschaltbild einer Beleuchtungseinrichtung;
- Figur 4: einen schematischen Schnitt durch ein Laserlichtmodul;
- Figuren 5 und 6: in schematischer Form ein Lichtintensität-Zeit-Diagramm;
- Figur 7: ein schematisches Zeitdauer-Zeit-Diagramm; und
- Figur 8: ein schematisches Ablaufdiagramm.

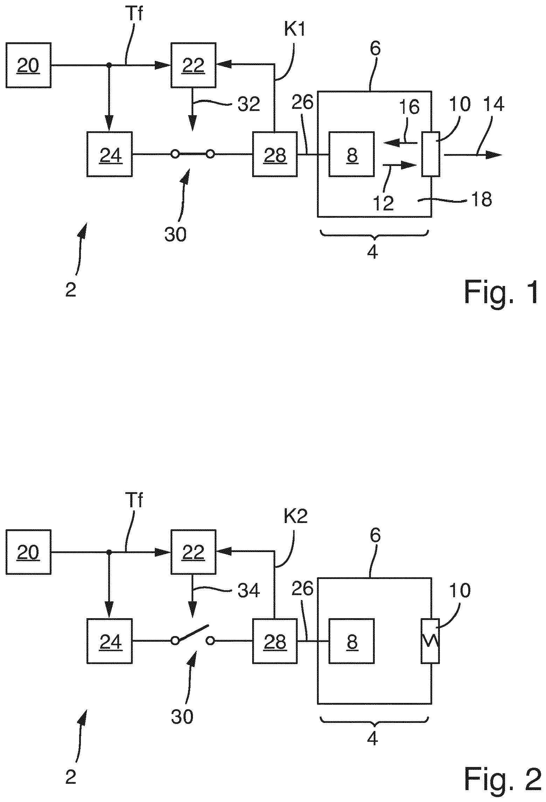

Figur 1 zeigt ein schematisches Blockschaltbild einer Beleuchtungseinrichtung 2 für ein Kraftfahrzeug, wobei es sich bei der Beleuchtungseinrichtung 2 beispielsweise um einen Scheinwerfer oder um eine Rückfahrleuchte handeln kann. Die Beleuchtungseinrichtung 2 umfasst ein Laserlichtmodul 4, welches aus zumindest einem Gehäuse 6, einer Laserdiode 8 und einem Photolumineszenzelement 10 besteht. Die Laserdiode 8 erzeugt beispielsweise unter Zuhilfenahme von Primäroptiken ein Primärlichtbündel 12, welches auf das Photolumineszenzelement 10 trifft. Das Photolumineszenzelement 10 wandelt das auftreffende Laserlicht des Primärlichtbündels 12 in gestreutes Laserlicht und Lumineszenzlicht. Ein erster Teil des gestreuten Laserlichts und des Lumineszenzlichts wird in Form eines abgestrahlten Mischlichtbündels 14 von dem Laserlichtmodul 4 abgestrahlt. Das Mischlichtbündel 14 kann weiteren optischen Elementen, wie beispielsweise Linsen oder Reflektoren zugeführt werden, um anschließend vom Fahrzeug gemäß einer gewünschten Abstrahllichtverteilung abgestrahlt zu werden. Ein zweiter Teil des gestreuten Laserlichts und des Lumineszenzlichts wird in Form eines rückgestrahlten Mischlichtbündels 16 in einen Innenraum 18 des Gehäuses 6 hinein gestrahlt.

Des Weiteren weist die Beleuchtungseinrichtung 2 eine erste Steuereinheit 20 und eine zweite Steuereinheit 22 auf. Die erste und die zweite Steuereinheit 20, 22 können auch gemeinsam als eine gemeinsame Steuereinheit ausgebildet sein. Die erste Steuereinheit 20 betreibt eine Leistungselektronik 24 derart, dass die Laserdiode 8 getaktet betrieben wird. Dieses Takten der Laserdiode 8 umfasst beispielsweise eine Zuführung eines Rechteck-Spannungssignals mit steigenden und fallenden Flanken. Selbstverständlich sind aber auch andere Signalformen denkbar, welche über eine Versorgungsleitung 26 von der Leistungselektronik 24 ausgehend der Laserdiode 8 zugeführt werden können.

Auf der Versorgungsleitung 26 ist ein Strommessglied 28 und ein Schalter 30 in Serie angeordnet. In dem gezeigten Normalbetrieb ist der Schalter 30 geschlossen, wodurch die Leistungselektronik 24 die Laserdiode 8 zu dem getakteten Betrieb über die Versorgungsleitung 26 mit elektrischer Energie versorgt. Das Strommessglied 28 und die Laserdiode 8 werden gemeinsam auch als Messvorrichtung zur Ermittlung der Lichtintensität des rückgestrahlten Lumineszenzlichts bezeichnet.

Die erste Steuereinheit 20 übermittelt einen Zeitpunkt Tf einer fallenden Flanke einer Steuerspannung an die zweite Steuereinheit 22. Der Zeitpunkt Tf kann auch anders ermittelt werden und sich beispielsweise auf eine fallende Flanke der Lichtintensität des Primärlichtbündels 12 beziehen. Insbesondere ist auch eine Messung der Lichtintensität des Primärlichtbündels 12 denkbar, um den Zeitpunkt Tf zu ermitteln.

Mittels des Strommessglied 28, welches auf der Versorgungsleitung 26 angeordnet ist, wird nach dem Zeitpunkt Tf die Laserdiode 8 als Photodiode betrieben und eine Lichtintensität K1 des rückgestrahlten, getakteten Lumineszenzlichts aus dem rückgestrahlten, getakteten Mischlichtbündel 16 ermittelt und an die zweite Steuereinheit 22 übermittelt. In Abhängigkeit von der ermittelten Lichtintensität K1 stellt die zweite Steuereinheit 22 fest, dass das Laserlichtmodul 4 fehlerfrei funktioniert und lässt gemäß einem erzeugten Signal 32 den Schalter 30 geschlossen.

Figur 2 zeigt ein schematisches Blockschaltbild der Beleuchtungseinrichtung 2 aus Figur 1. Im Unterschied zu Figur 1 ist in Figur 2 das Photolumineszenzelement 10 beschädigt, beispielsweise durch einen Bruch oder eine Verformung. Die Beschädigung des Photolumineszenzelements 10 führt dazu, dass weniger Lumineszenzlicht erzeugt wird als im fehlerfreien Fall. Entsprechend umfasst das rückgestrahlte getakteten Mischlichtbündel 16 einen geringeren Anteil an rückgestrahltem, getakteten Lumineszenzlichts. Bei einer abfallenden Flanke des Primärlichtbündels 12 bewirkt der verringerte Anteil des rückgestrahlten Lumineszenzlichts in dem Mischlichtbündel 16, dass ein Nachleuchten des Lumineszenzlichts gegenüber dem fehlerfreien Betrieb reduziert ist.

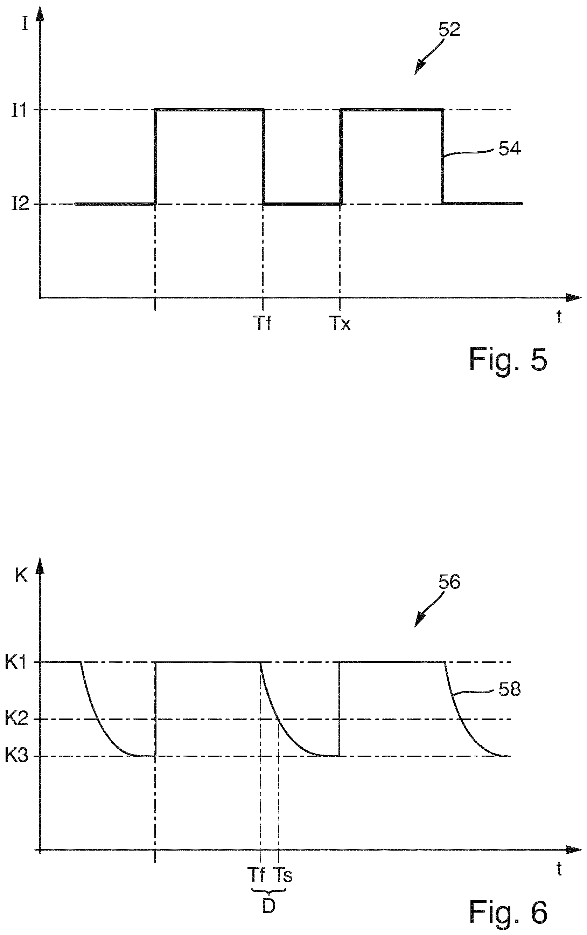

Das Lumineszenzlicht ist auch als Fluoreszenzlicht bezeichenbar. Nach der Reduktion der Laserintensität nimmt die Intensität des Lumineszenzlichts nicht sofort ab, sondern das Lumineszenzlicht leuchtet nach und fällt exponentiell ab. Grund hierfür ist die Lebensdauer der angeregten Zustände in dem Leuchtstoff des Photolumineszenzelement 10. Nachleuchten bedeutet somit, dass das das Photolumineszenzelement 10 etwas Zeit benötigt, bis das längerwellige Lumineszenzlicht konvertiert wird. Daher setzt auch zu Beginn der Lasereinstrahlung beispielsweise bei einer steigenden Flanke der Laserlichtintensität die Fluoreszenzstrahlung etwas verzögert ein, was allerdings in Figur 6 aus Übersichtsgründen vereinfacht dargestellt ist.

Ist das Laserlichtmodul 4 beschädigt, so misst das Strommessglied 28 entsprechend eine gegenüber der Lichtintensität K1 verringerte Lichtintensität K2. In Abhängigkeit von der verringerten Lichtintensität K2 ermittelt die zweite Steuereinheit 22 ein Abschaltsignal 35, welches den Schalter 30 öffnet und die Laserdiode 8 von der Leistungselektronik 24 trennt.

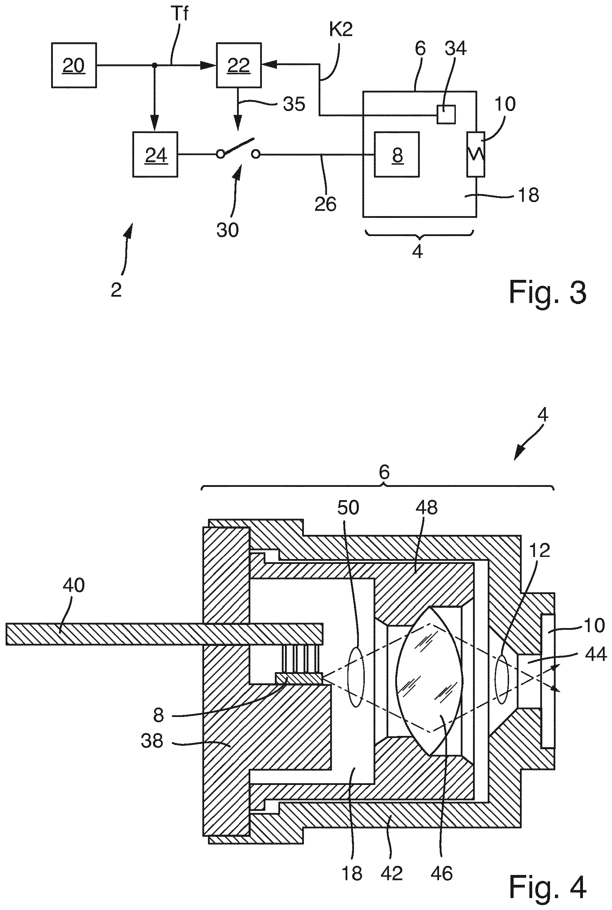

Figur 3 zeigt in schematischer Form eine Beleuchtungseinrichtung 2, welche nicht unter die vorliegende Erfindung fällt, in der Betriebsart, welche Figur 2 dargestellt ist. Im Unterschied zu den Figuren 1 und 2 ist in Figur 3 kein Strommessglied 28 auf der Versorgungsleitung 26 angeordnet. Vielmehr ist eine Photodiode 34 in dem Innenraum 18 des Gehäuses 6 angeordnet, welche die Lichtintensität K des rückgestrahlten, getakteten Lumineszenzlichts in dem rückgestrahlten, getakteten Mischlichtbündel 16 erfasst.

Vorliegend wird die verminderte Lichtintensität K2 von der Photodiode 34 ermittelt, welche zu einem Öffnen des Schalters 30 mittels des erzeugten Abschaltsignals 35 führt und damit die Laserdiode 8 von der Energieversorgung abtrennt.

Die beschriebenen Verfahrensschritte in dieser Beschreibung können beispielsweise als Computerprogramme ausgeführt und auf entsprechenden Speichermedien abgespeichert sein. Die Steuereinheiten 20 und 22 enthalten diese Speichereinheiten sowie jeweilige Prozessoren, auf denen die in dieser Beschreibung angeführten Funktionen als Computerprogramm ausgeführt werden.

Figur 4 zeigt einen schematischen Schnitt durch ein Laserlichtmodul 4. Das Gehäuse 6 umfasst eine Grundplatte 38, auf welcher die Laserdiode 8 angeordnet ist. Ein Pin 40 dient der Stromversorgung der Laserdiode 8 und ist an die Versorgungsleitung 26 angeschlossen. Des Weiteren umfasst das Gehäuse 6 eine an der Grundplatte 38 angeordnete Gehäusekappe 42, an deren dem Pin 40 gegenüberliegenden Ende sich eine Öffnung 44 befindet. Die Öffnung 44 ist mit dem Photolumineszenzelement 10 verschlossen. Neben der Photodiode 8 ist in den Innenraum 18 eine Linse 46 mittels einer Linsenhalterung 48 gehalten. Die Linse 46 ist dazu derart angeordnet, so dass ein divergierendes Laserlichtbündel 50 in ein auf das Photolumineszenzelement 10 gerichtetes Primärlichtbündel 12 umgewandelt wird. Das gezeigte Laserlichtmodul 4 kann als TO package (TO: Transistor Outline) ausgeführt sein, um beispielsweise als kompaktes Modul mit einer Leiterplatte verbunden zu werden.

Figur 5 zeigt in schematischer Form ein Lichtintensität-Zeit-Diagramm 52 mit einem Intensitätsverlauf 54 des Primärlichtbündels 12. Der Zeitpunkt Tf einer abfallenden Flanke der Lichtintensität I von einem Intensitätswert I1 auf einen Intensitätswert 12 ist gezeigt. Der Lichtintensitätswert 12 kann auch einen Wert von Null bedeuten. Zu einem weiteren Zeitpunkt Tx steigt die Lichtintensität I des Primärlichtbündels 12 wieder an.

Selbstverständlich können weitere Funktionen die Modulation der Lichtintensität I des Primärlichtbündels 12 beeinflussen. So können beispielsweise durch eine Pulsweitenmodulation des Verlaufs 54 Nutzdaten an andere Verkehrsteilnehmer übermittelt werden, ohne dass dies die Sichteigenschaften wesentlich beeinträchtigt. Selbst bei einer solchen Intensitätsmodulation in Form einer Pulsweitenmodulation sind die hier beschriebenen Verfahren weiter anwendbar.

Figur 6 zeigt in schematischer Form ein Lichtintensität-Zeit-Diagramm 56. Es ist ein Verlauf 58 einer Intensität K des getakteten, rückgestrahlten Lumineszenzlichts gezeigt. Wie vorangehend beschrieben, leuchtet das Lumineszenzlicht nach und die Lichtintensität K fällt nach dem Abschalten bzw. der abfallenden Flanke zu dem Zeitpunkt Tf von dem ersten Intensitätswert K1 auf einen dritten Intensitätswert K3 ab bzw. nähert sich diesem an. Zu einem Zeitpunkt Ts unterschreitet die Lichtintensität K den zweiten Lichtintensitätswert K2. Die zweite Steuereinheit 22 ermittelt entsprechend eine Zeitdauer D zwischen den Zeitpunkten Tf und Ts.

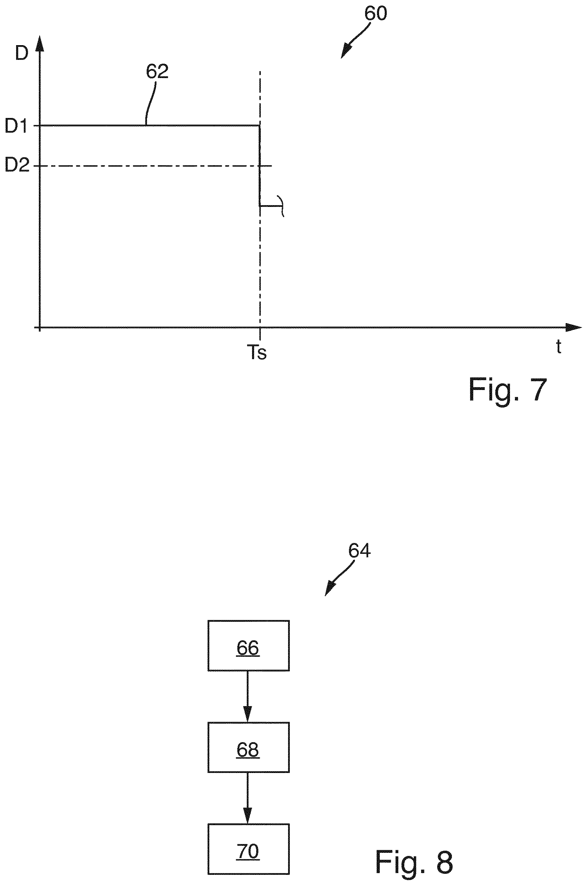

Figur 7 zeigt ein schematisches Zeitdauer-Zeit-Diagramm 60. Die Zeitdauer D wird auch als nach Nachleuchtzeitdauer bezeichnet. Fällt die Nachleuchtzeitdauer D gemäß dem gezeigten Verlauf 62 ausgehend von einem ersten Wert D1 unter einen zweiten Wert D2, so wird das Abschaltsignal 35 zum Öffnen des Schalters 30 mittels der 2. Steuereinheit 22 erzeugt, womit zum Zeitpunkt Ts die Leuchtdiode 8 abgeschaltet wird.

Figur 8 zeigt ein schematisches Ablaufdiagramm 64, welches mittels der Steuereinheit 22 ausgeführt wird. Gemäß einem ersten Block 66 wird der erste Zeitpunkt Tf der fallenden Flanke des getakteten Primärlichtbündels 12 ermittelt. In einem folgenden Block 68 wird der zweite Zeitpunkt Ts, zu dem die Lichtintensität K des zu rückgestrahlten, getakteten Lumineszenzlichts unter den vorgegebenen Lichtintensitätswert K2 fällt, ermittelt. In dem folgenden Block 70 wird die Laserdiode 8 in Abhängigkeit von den ermittelten ersten und zweiten Zeitpunkten Tf, Ts, insbesondere in Abhängigkeit von der Zeitdauer D zwischen den beiden Zeitpunkten Tf, Ts, abgeschaltet.

Selbstverständlich können auch andere als das gezeigte Verfahren zum Auswerten der ermittelten Lichtintensitätswerte des getakteten rückgestrahlten Lumineszenzlichts verwendet werden, um die Laserdiode 8 abzuschalten.

## Patentansprüche

1. Eine Beleuchtungseinrichtung (2) für ein Kraftfahrzeug mit einem Laserlichtmodul (4) umfassend eine Laserdiode (8) und ein Photolumineszenzelement (10), wobei ein mittels der Laserdiode (8) erzeugtes, getaktetes Primärlichtbündel (12) auf das Photolumineszenzelement (10) trifft, und wobei das Photolumineszenzelement (10) das auftreffende Primärlichtbündel (12) in ein von dem Laserlichtmodul (4) abgestrahltes, getaktetes Mischlichtbündel (14) und in ein in das Laserlichtmodul (4) rückgestrahltes, getaktetes Mischlichtbündel (16) umfassend Lumineszenzlicht wandelt, wobei die Lichtintensität (K) des rückgestrahlten, getakteten Lumineszenzlichts mittels einer Messvorrichtung ermittelbar ist, und wobei die Laserdiode (8) in Abhängigkeit von der ermittelten Lichtintensität (K) des rückgestrahlten, getakteten Lumineszenzlichts abschaltbar ist, **dadurch gekennzeichnet,**
- **dass** die Messvorrichtung zur Ermittlung der Lichtintensität (K) die Laserdiode (8) und ein in einer Versorgungsleitung (26) der Laserdiode (8) angeordnetes Strommessglied (28) umfasst, wobei ein von dem Strommessglied (28) ermittelter Stromwert die Lichtintensität (K) des rückgestrahlten Lumineszenzlichts repräsentiert.

2. Die Beleuchtungseinrichtung (2) nach einem der vorstehenden Ansprüche,
- wobei das Laserlichtmodul (4) ein im Wesentlichen lichtdichtes Gehäuse (6) umfasst,
- wobei in eine Öffnung (44) des Gehäuses (6) das Photolumineszenzelement (10) eingebracht ist, und
- wobei die Lichtintensität (K) des rückgestrahlten Lumineszenzlichts in einem Innenraum (18) des lichtdichten Gehäuses (6) erfasst wird.

3. Die Beleuchtungseinrichtung (2) nach einem der vorstehenden Ansprüche,
- wobei ein erster Zeitpunkt (Tf) einer fallenden Flanke des getakteten Primärlichtbündels (12) ermittelbar ist,
- wobei ein zweiter Zeitpunkt (Ts) ermittelbar ist, zu dem die Lichtintensität (K) des rückgestrahlten, getakteten Lumineszenzlichts unter einen vorgegebenen Lichtintensitätswert (K2) fällt, und
- wobei die Laserdiode (8) in Abhängigkeit von dem ersten und dem zweiten Zeitpunkt (Tf, Ts) abschaltbar ist.

4. Ein Verfahren zum Betreiben einer Beleuchtungseinrichtung (2) für ein Kraftfahrzeug mit einem Laserlichtmodul (4) umfassend eine Laserdiode (8) und ein Photolumineszenzelement (10), wobei ein mittels der Laserdiode (8)erzeugtes, getaktetes Primärlichtbündel (12) auf das Photolumineszenzelement (10) trifft, und wobei das Photolumineszenzelement (10) das auftreffende Primärlichtbündel (12) in ein von dem Laserlichtmodul (4) abgestrahltes, getaktetes Mischlichtbündel (14) und in ein in das Laserlichtmodul (4) rückgestrahltes, getaktetes Mischlichtbündel (16) umfassend Lumineszenzlicht wandelt, wobei die Lichtintensität (K) des rückgestrahlten, getakteten Lumineszenzlichts mittels einer Messvorrichtung ermittelt wird, und wobei die Laserdiode (8) in Abhängigkeit von der ermittelten Lichtintensität (K) des rückgestrahlten, getakteten Lumineszenzlichts abgeschaltet wird, **dadurch gekennzeichnet,**
- **dass** die Messvorrichtung die Laserdiode (8) und ein in einer Versorgungsleitung (26) der Laserdiode (8) angeordnetes Strommessglied (28) umfasst, wobei ein von dem Strommessglied (28) ermittelter Stromwert die Lichtintensität (K) des rückgestrahlten Lumineszenzlichts repräsentiert.

5. Das Verfahren nach dem Anspruch 4 zum Betreiben der Beleuchtungseinrichtung (2) nach einem der Ansprüche 2 bis 3.

## Claims

1. A lighting device (2) for an automobile, having a laser light module (4) comprising a laser diode (8) and a photoluminescence element (10), wherein a clocked primary light beam (12) generated by means of the laser diode (8) impinges on the photoluminescence element (10) and wherein the photoluminescence element (10) converts the incident primary light beam (12) into a clocked mixed light beam (14) emitted by the laser light module (4) and into a clocked mixed light beam (16) returned into the laser light module (4) and comprising luminescent light, wherein the light intensity (K) of the returned clocked luminescent light can be determined by means of a measuring device, and wherein the laser diode (8) can be switched off depending on the determined light intensity (K) of the returned clocked luminescent light, **characterized in**
- **that** the measuring device for determinig the light intensity (K) comprises the laser diode (8) and a current sensing element (28) arranged in a supply line of the laser diode (8), wherein a current value determined by the current sensing element (28) represents the light intensity (K) of the returned luminescent light.

2. The lighting device (2) as claimed in one of the preceding claims,
- wherein the laser light module (2) comprises a housing (6) which is substantally lightproof,
- wherein the photoluminescence element is inserted into an opening (44) of the housing (6), and
- wherein the light intensity (K) of the returned luminescent light is measured in an interior (18) of the lightproof housing (6).

3. The lighting device (2) as claimed in one of the preceding claims,
- wherein a first point in time (Tf) of a falling edge of the clocked primary light beam (12) can be determined,
- wherein a second point in time (Ts) can be determined, when the light intensity (K) of the returned clocked luminescent light falls under a predetermined light intensity value (K2), and
- wherein the laser diode (8) can be switched off depending on the first and second point in time (Tf, Ts).

4. A method for operating a lighting device (2) for an automobile having a laser light module (4), comprising a laser diode (8) and a photoluminescence element (10), wherein a clocked primary light beam (12) generated by means of the laser diode (8) impinges on the photoluminescence element (10), and wherein the photoluminescence element (10) converts the incident primary light beam (12) into a clocked mixed light beam (14) emitted by the laser light module (4) and into a clocked mixed light beam (16) returned into the laser light module (4) and comprising luminescent light, wherein the light intensity (K) of the returned clocked luminescent light is determined by means of a measuring device and wherein the laser diode (8) is switched off depending on the determined light intensity (K) of the returned clocked luminescent light, **characterized in**
- **that** the measuring device comprises the laser diode (8) and a current sensing element (28) arranged in a supply line of the laser diode (8), wherein a current value determined by the current sensing element (28) represents the light intensity (K) of the returned luminescent light.

5. The method as claimed in claim 4 for operating a lighting device (2) as claimed in one of claims 2 to 3.

## Revendications

1. Dispositif d'éclairage (2) pour un véhicule automobile ayant un module de lumière laser (4) comprenant une diode laser (8) et un élément photoluminescent (10), dans lequel un faisceau de lumière primaire cadencé (12) généré au moyen de la diode laser (8) est incident sur l'élément photoluminescent (10), et dans lequel l'élément photoluminescent (10) convertit le faisceau de lumière primaire (12) incident en un faisceau de lumière mixte cadencé (14) émis par le module de lumière laser (4) et en un faisceau de lumière mixte cadencé (16) qui comprend de la lumière luminescente et est réfléchi dans le module de lumière laser (4), dans lequel l'intensité lumineuse (K) de la lumière luminescente cadencée réfléchie peut être déterminée au moyen d'un dispositif de mesure, et dans lequel la diode laser (8) peut être éteinte en fonction de l'intensité lumineuse (K) déterminée de la lumière luminescente cadencée réfléchie, **caractérisé par le fait**
- **que** le dispositif de mesure destiné à déterminer l'intensité lumineuse (K) comprend la diode laser (8) et un élément de mesure de courant (28) disposé dans une ligne d'alimentation (26) de la diode laser (8), dans lequel une valeur de courant déterminée par l'élément de mesure de courant (28) représente l'intensité lumineuse (K) de la lumière luminescente réfléchie.

2. Dispositif d'éclairage (2) selon l'une quelconque des revendications précédentes,
- dans lequel le module de lumière laser (4) comprend un boîtier (6) pour l'essentiel étanche à la lumière,
- dans lequel l'élément photoluminescent (10) est introduit dans une ouverture (44) du boîtier (6), et
- dans lequel l'intensité lumineuse (K) de la lumière luminescente réfléchie est détectée dans un intérieur (18) du boîtier (6) étanche à la lumière.

3. Dispositif d'éclairage (2) selon l'une quelconque des revendications précédentes,
- dans lequel un premier instant (Tf) d'un front descendant du faisceau de lumière primaire cadencé (12) peut être déterminé,
- dans lequel un deuxième instant (Ts) peut être déterminé auquel l'intensité lumineuse (K) de la lumière luminescente cadencée réfléchie tombe en dessous d'une valeur d'intensité lumineuse (K2) prédéterminée, et
- dans lequel la diode laser (8) peut être éteinte en fonction des premier et deuxième instants (Tf, Ts).

4. Procédé destiné à faire fonctionner un dispositif d'éclairage (2) pour un véhicule automobile ayant un module de lumière laser (4) comprenant une diode laser (8) et un élément photoluminescent (10), dans lequel un faisceau de lumière primaire cadencé (12) généré au moyen de la diode laser (8) est incident sur l'élément photoluminescent (10), et dans lequel l'élément photoluminescent (10) convertit le faisceau de lumière primaire (12) incident en un faisceau de lumière mixte cadencé (14) émis par le module de lumière laser (4) et en un faisceau de lumière mixte cadencé (16) qui comprend de la lumière luminescente et est réfléchi dans le module de lumière laser (4), dans lequel l'intensité lumineuse (K) de la lumière luminescente cadencée réfléchie est déterminée au moyen d'un dispositif de mesure, et dans lequel la diode laser (8) est éteinte en fonction de l'intensité lumineuse (K) déterminée de la lumière luminescente cadencée réfléchie, **caractérisé par le fait**
- **que** le dispositif de mesure comprend la diode laser (8) et un élément de mesure de courant (28) disposé dans une ligne d'alimentation (26) de la diode laser (8), dans lequel une valeur de courant déterminée par l'élément de mesure de courant (28) représente l'intensité lumineuse (K) de la lumière luminescente réfléchie.

5. Procédé selon la revendication 4, destiné à faire fonctionner le dispositif d'éclairage (2) selon l'une quelconque des revendications 2 à 3.
